# EUROPEAN PATENT SPECIFICATION

(11) **EP 4 280 833 B1**
(45) Date of publication and mention of the grant of the patent: **25.11.2026**
(21) Application number: 23171312.4
(22) Date of filing: 03.05.2023
(51) Int. Cl.: H05K 7/20

(54) **METHODS AND SYSTEMS FOR PRIORITIZING MAINTENANCE OF COOLING UNITS OF A DATA CENTER**
VERFAHREN UND SYSTEME ZUR PRIORISIERUNG DER WARTUNG VON KÜHLEINHEITEN EINES DATENZENTRUMS
PROCÉDÉS ET SYSTÈMES POUR ÉTABLIR DES PRIORITÉS DE MAINTENANCE D'UNITÉS DE REFROIDISSEMENT D'UN CENTRE DE DONNÉES

(30) Priority: 17.05.2022 US 202217746670
(43) Date of publication of application: 22.11.2023
(73) Proprietor: Honeywell International Inc., Charlotte, NC 28202 (US)
(72) Inventor: MERUVA, Jayaprakash, Charlotte, 28202 (US); KAMATH, Madhav V., Charlotte, 28202 (US); LINGAN, Magesh, Charlotte, 28202 (US); NAGARAJ, Srikanth, Charlotte, 28202 (US)
(74) Representative: Houghton, Mark Phillip

(56) References cited:
- US-A1- 2010 312 415
- US-A1- 2012 109 405
- US-A1- 2014 188 434

## Description

### Technical Field

The present disclosure pertains generally to cooling units of a data center and more particularly to prioritizing maintenance of the cooling units of a data center.

### Background

A data center typically includes a number of computer servers in close proximity to each other arranged in server racks. Because of the heat generated by having a number of computer servers in close proximity to each other, a data center includes numerous cooling equipment such as CRAC (computer room air conditioners) units and/or CRAH (computer room air handlers) units in order to control environmental conditions such as temperature within and around each of the server racks. Cooling units such as CRAC units and CRAH units undergo periodic maintenance. In some cases, a cooling unit may develop problems outside of a periodic maintenance schedule, which can increase maintenance costs by requiring non-scheduled visits by service personnel and in some cases non-scheduled down time of part of the data center. A need remains for improved methods and systems of anticipating and scheduling maintenance for the cooling units of a data center.

Examples of currently used systems can be found in the following documents:
US2010/312415A1, which discloses a system for detecting changes in equipment cooling performance, by indirectly measuring cooling performance by way of a cooling efficiency indicator. An operating cooling efficiency indicator is calculated as a ratio between equipment electrical power consumption and a temperature differential between the equipment and an ambient temperature. The operating cooling efficiency indicator is compared to a baseline cooling efficiency indicator to detect changes in cooling performance.

US2012/109405A1, which discloses a data center includes a container with a raised floor defining a number of openings, and a server system received in the container. The server system includes a rack and a number of servers received in the rack at different heights. Cooling air is released by a cooling device. A number of pressurizing fans are arranged under the raised floor aligned with the openings to drive the cooling air to flow upwards through the openings. A number of temperature sensors are mounted to the rack to sense temperatures of air flowing out of the servers. The temperatures sensed by the temperature sensors are transmitted to a computing unit. According to the temperatures, the computing unit adjusts the speeds of the pressurizing fans to make the cooling air within the container be better distributed for evenly cooling the servers.

US2014/188434A1, which discloses a method for determining whether to perform maintenance for an electronic device includes generating a baseline characterization of thermal performance for a heat-generating component of the electronic device at a baseline date. The method also includes generating an assessment characterization of the thermal performance at an assessment date after the baseline date. The method further includes generating a historical trend that includes the baseline characterization and the assessment characterization. Additionally, the method includes determining whether to perform maintenance for the heat-generating component based on the historical trend and a specified maintenance parameter.

### Summary

This disclosure relates generally to improved methods and systems for anticipating and scheduling maintenance for the cooling units of a data center. An example may be found in a method of identifying one or more cooling units of a plurality of cooling units servicing a data center that has a reduced relative performance level relative to other of the plurality of cooling units. The illustrative method includes monitoring a performance level of each of the plurality of cooling units. The illustrative method further includes, for each of the plurality of cooling units, identifying one or more of the plurality of cooling units as one or more neighboring cooling units to the respective cooling unit, wherein the one or more neighboring cooling units to the respective cooling unit include less than all of the remaining ones of the plurality of cooling units of the data center, comparing the performance level of the respective cooling unit to the performance level of each of the one or more neighboring cooling units, determining that the respective cooling unit has a reduced relative performance level relative to the neighboring cooling units when the performance level of the respective cooling unit falls below the performance level of one or more of the neighboring cooling units by at least a threshold amount, and in response to determining that at least one of the respective cooling units has a reduced relative performance level, issuing an alert.

Another example may be found in a method of scheduling maintenance for a plurality of cooling units of a data center. The illustrative method includes receiving a plurality of sensor signals from a plurality of sensors and training a machine learning model based at least in part on the plurality of sensor signals to model a performance level of each of the plurality of cooling units and a degradation in the performance level of each of the plurality of cooling units over time. The method includes using a machine learning engine that references the trained machine learning model and the plurality of sensor signals to identify one or more of the plurality of cooling units that has a degradation in the performance level (which may include a projected degradation in the performance level based on the trained machine learning model) that is greater than the degradation in the performance level (which may include a projected degradation in the performance level based on the trained machine learning model) of at least one other of the plurality of cooling units by at least a threshold amount. A maintenance schedule is created for the plurality of cooling units, wherein the maintenance schedule prioritizes the one or more of the plurality of cooling units identified as having a degradation in the performance level that is greater than the degradation in the performance level of at least one other of the plurality of cooling units by at least a threshold amount. Maintenance is performed on the plurality of cooling units according to the maintenance schedule.

Another example may be found in instructions stored on a non-transient computer readable storage medium. When the instructions are executed by one or more processors, the one or more processors are caused to receive a plurality of sensor signals from a plurality of sensors and to derive a performance level of each of a plurality of cooling units servicing a data center based at least in part on the plurality of sensor signals. The one or more processors are caused to identify one or more of the plurality of cooling units that has a degradation in the performance level that is greater than the degradation in the performance level of at least one other of the plurality of cooling units by at least a threshold amount. The one or more processors are caused to create a maintenance schedule for the plurality of cooling units, wherein the maintenance schedule prioritizes the one or more of the plurality of cooling units identified as having a degradation in the performance level that is greater than the degradation in the performance level of at least one other of the plurality of cooling units by at least a threshold amount.

The preceding summary is provided to facilitate an understanding of some of the features of the present disclosure and is not intended to be a full description. A full appreciation of the disclosure can be gained by taking the entire specification, claims, drawings, and abstract as a whole.

### Brief Description of the Drawings

The disclosure may be more completely understood in consideration of the following description of various illustrative embodiments of the disclosure in connection with the accompanying drawings, in which:
Figure 1 is a schematic block diagram showing an illustrative data center;
Figure 2 is a flow diagram showing an illustrative method;
Figures 3A and 3B are flow diagrams that together show an illustrative method;
Figures 4A and 4B are flow diagrams that together show an illustrative method;
Figure 5 is a flow diagram showing an illustrative method;
Figure 6 is a flow diagram showing an illustrative method;
Figure 7 is a schematic block diagram showing an illustrative control system for the illustrative data center of Figure 1;
Figure 8 is a flow diagram showing an illustrative method; and
Figures 9A and 9B are flow diagrams that together show an illustrative method.

While the disclosure is amenable to various modifications and alternative forms, specifics thereof have been shown by way of example in the drawings and will be described in detail. It should be understood, however, that the intention is not to limit aspects of the disclosure to the particular illustrative embodiments described. On the contrary, the intention is to cover all modifications, equivalents, and alternatives falling within the scope of the disclosure.

### Description

The following description should be read with reference to the drawings wherein like reference numerals indicate like elements. The drawings, which are not necessarily to scale, are not intended to limit the scope of the disclosure. In some of the figures, elements not believed necessary to an understanding of relationships among illustrated components may have been omitted for clarity.

All numbers are herein assumed to be modified by the term "about", unless the content clearly dictates otherwise. The recitation of numerical ranges by endpoints includes all numbers subsumed within that range (e.g., 1 to 5 includes 1, 1.5, 2, 2.75, 3, 3.80, 4, and 5).

As used in this specification and the appended claims, the singular forms "a", "an", and "the" include the plural referents unless the content clearly dictates otherwise. As used in this specification and the appended claims, the term "or" is generally employed in its sense including "and/or" unless the content clearly dictates otherwise.

It is noted that references in the specification to "an embodiment", "some embodiments", "other embodiments", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is contemplated that the feature, structure, or characteristic may be applied to other embodiments whether or not explicitly described unless clearly stated to the contrary.

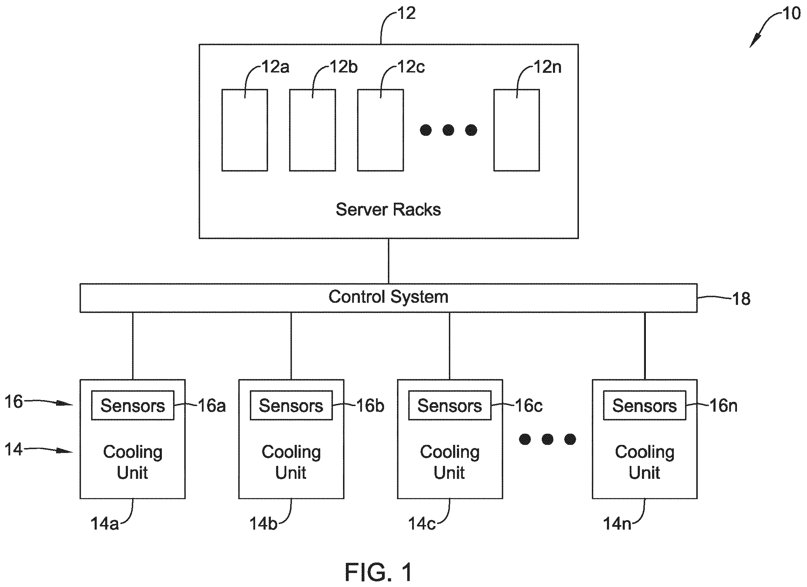

Figure 1 is a schematic block diagram of an illustrative data center 10. The illustrative data center 10 includes a number of server racks 12, individually labeled as 12a, 12b, 12c and through 12n. The data center 10 may include any number of server racks 12. Each of the server racks 12 may include a plurality of individual computer servers, sometimes referred to as server blades. It will be appreciated that having a large number of computer servers in a confined space can generate significant heat. As a result, the data center 10 includes a number of cooling units 14, individually labeled as 14a, 14b, 14c and through 14n. Wherein, the cooling units 14 are CRAC (computer room air conditioner) units, an/or CRAH (computer room air handler) units.

In some cases, there may be a particular cooling unit 14 assigned to a particular server rack 12. In some cases, a particular cooling unit 14 may be assigned to two or more server racks 12. In some instances, two or more cooling units 14 may be assigned to a single server rack 12. These are just examples.

Each of the cooling units 14 include one or more sensors 16, individually labeled as 16a, 16b, 16c and through 16n. Each sensor 16 may be a single sensor. Each sensor 16 may represent two or more different sensors within or associated with a particular cooling unit 14. Some of the sensors 16 may be air flow sensors, configured to measure air flow before and after a filter or other component of one of the cooling units 14. Some of the sensors 16 may be temperature sensors, configured to measure the temperature of cooling water before and after a cooling coil, for example. Some of the sensors 16 may be humidity sensors, particular matter (PM) sensors, CO sensors and/or any other suitable sensor useful in controlling the environment within the data center 10.

The sensors 16 and the cooling units 14 may be operably coupled with a control system 18. The control system 18 may control operation of the cooling units 14 in order to maintain the data center 10 and the server racks 12 within a desired environmental range (e.g. temperature range and/or humidity range). In some instances, the control system 18 may also regulate operation of the server racks 12, such as fans associated with the server racks. In some cases, the control system 18 may be locally situated within the data center 10, and may be implemented within one or more edge devices. In some cases, the control system 18 may be located remote from the data center 10, and may be disposed within a cloud-based server. In some cases, the control system 18 may be implemented within one or more server blades disposed within one of the server racks 12. In some cases, the control system 18 may be a distributed control system, with some features implemented locally (e.g. at the edge) and other features implemented remotely (e.g. in the cloud).

In some instances, the control system 18 may implement a number of different methods in determining which cooling units 14 are in need of maintenance, and when that maintenance should be performed in order to provide optimal performance of the cooling units 14 and thus the data center 10. The following figures provide examples of such methods.

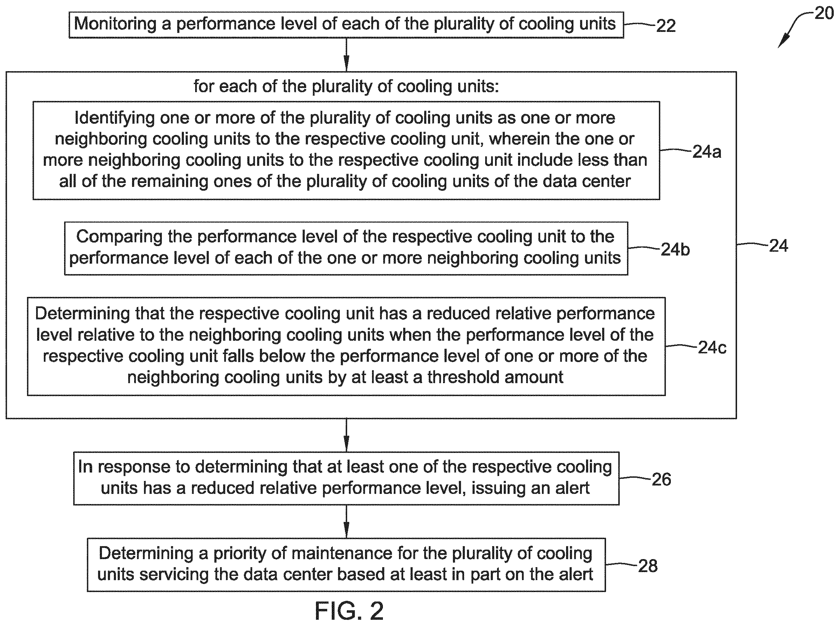

Figure 2 is a flow diagram showing an illustrative method 20 of identifying one or more cooling units of a plurality of cooling units (such as the cooling units 14) servicing a data center (such as the data center 10) that has a reduced relative performance level relative to other of the plurality of cooling units. The method 20 includes monitoring a performance level of each of the plurality of cooling units, as indicated at block 22. In some cases, the performance level that is monitored may include an airflow parameter indicative of an air flow through an air filter of the respective cooling unit. The performance level that is monitored may include a temperature drop across a cooling coil of the respective cooling unit. These are just examples.

For each of the plurality of cooling units, as indicated at block 24, a number of steps are carried out. One or more of the plurality of cooling units are identified as one or more neighboring cooling units to the respective cooling unit, wherein the one or more neighboring cooling units to the respective cooling unit include less than all of the remaining ones of the plurality of cooling units of the data center, as indicated at block 24a. The one or more neighboring cooling units may be defined using any suitable criteria. For example, the one or more of the plurality of cooling units identified as neighboring cooling units to the respective cooling unit may be predefined for each respective cooling unit in advance during commissioning of the data center 10. For example, the one or more of the plurality of cooling units identified as neighboring cooling units to the respective cooling unit may be predefined based on having a nearby physical or logical location to the respective cooling unit, such as on a same floor of the data center 10 and/or in a same zone of the data center 10. In another example, the one or more of the plurality of cooling units identified as neighboring cooling units to the respective cooling unit may be predefined based on having an expected heat load that is within a defined heat load range. In some cases, the one or more of the plurality of cooling units identified as neighboring cooling units to the respective cooling unit may be dynamically identified based on one or more sensed conditions. For example, the one or more of the plurality of cooling units identified as neighboring cooling units to the respective cooling unit may be dynamically defined based on having an actual heat load (e.g. an average heat load over a period of a day, a week, a month or any other suitable time period) that is within a defined heat load range. These are just examples.

The performance level of the respective cooling unit is compared to the performance level of each of the one or more neighboring cooling units, as indicated at block 24b. A determination is made that the respective cooling unit has a reduced relative performance level relative to the neighboring cooling units when the performance level of the respective cooling unit falls below the performance level of one or more of the neighboring cooling units by at least a threshold amount, as indicated at block 24c. The performance level of the cooling units may be determined using any suitable measure of performance of the cooling unit including, for example, an air flow through an air filter of the cooling unit, a temperature drop across a cooling coil of the cooling unit, a pressure, temperature and/or flow rate of cooling fluid entering and/or exiting the cooling coil of the cooling unit, a fan speed of the cooling unit, an electrical power draw of the cooling unit, and/or any other suitable measure of performance of the cooling unit.

In response to determining that at least one of the respective cooling units has a reduced relative performance level relative to its neighboring cooling units, an alert is issued, as indicated at block 26. In some cases, and as indicated at block 28, the method 20 may further include determining a priority of maintenance for the plurality of cooling units servicing the data center 10 based at least in part on the alert. This can be important because there may be many cooling units servicing a data center 10, such as many tens or even hundreds of cooling units, and performing periodic maintenance on all cooling units may take considerable time. Servicing the cooling units that are determined to have a reduced relative performance first may have the biggest impact on the performance of the data center in the near term and may reduce the chance of a more serious failure of a cooling unit that could result in part of the data center 10 operating under non-compliance conditions or even being taken off-line for service.

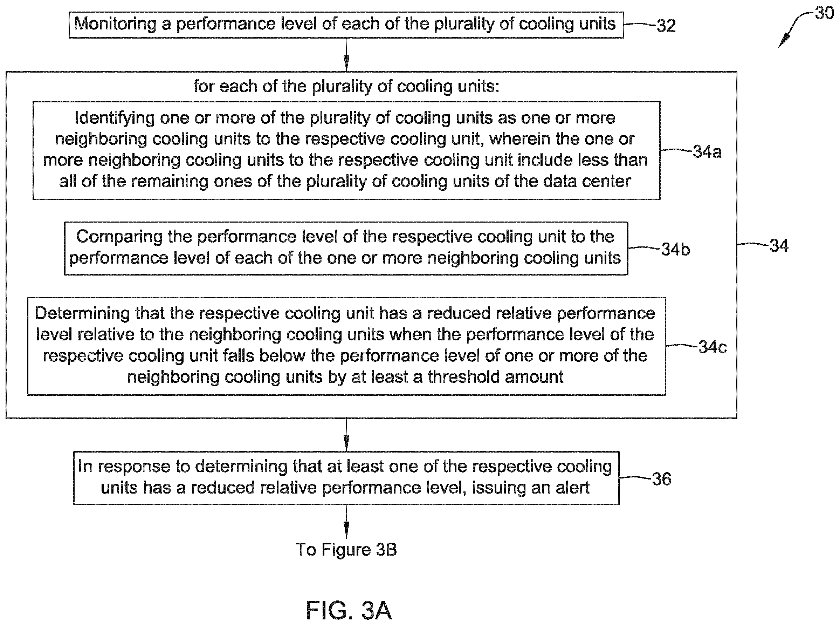

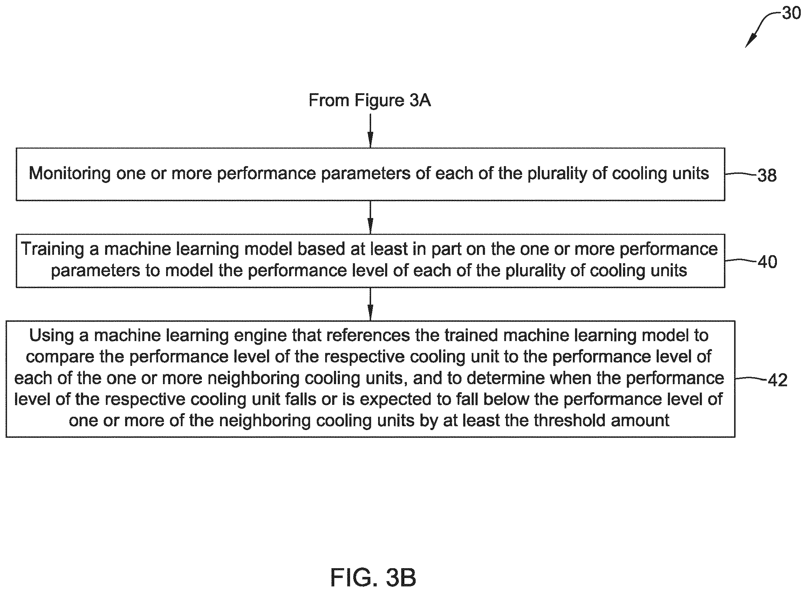

Figures 3A and 3B are flow diagrams that together show an illustrative method 30 of identifying one or more cooling units of a plurality of cooling units (such as the cooling units 14) servicing a data center (such as the data center 10) that has a reduced relative performance level relative to other of the plurality of cooling units. The method 30 includes monitoring a performance level of each of the plurality of cooling units, as indicated at block 32. In some cases, the performance level that is monitored may include an airflow parameter indicative of an air flow through an air filter of the respective cooling unit. The performance level that is monitored may include a temperature drop across a cooling coil of the respective cooling unit. These are just examples.

For each of the plurality of cooling units, as indicated at block 34, a number of steps are carried out. One or more of the plurality of cooling units are identified as one or more neighboring cooling units to the respective cooling unit, wherein the one or more neighboring cooling units to the respective cooling unit include less than all of the remaining ones of the plurality of cooling units of the data center, as indicated at block 34a. The one or more neighboring cooling units may be defined using any suitable criteria. For example, the one or more of the plurality of cooling units identified as neighboring cooling units to the respective cooling unit may be predefined for each respective cooling unit in advance during commissioning of the data center 10. For example, the one or more of the plurality of cooling units identified as neighboring cooling units to the respective cooling unit may be predefined based on having a nearby physical or logical location to the respective cooling unit, such as on a same floor of the data center 10 and/or in a same zone of the data center 10. In another example, the one or more of the plurality of cooling units identified as neighboring cooling units to the respective cooling unit may be predefined based on having an expected heat load that is within a defined heat load range. In some cases, the one or more of the plurality of cooling units identified as neighboring cooling units to the respective cooling unit may be dynamically identified based on one or more sensed conditions. For example, the one or more of the plurality of cooling units identified as neighboring cooling units to the respective cooling unit may be dynamically defined based on having an actual heat load (e.g. an average heat load over a period of a day, a week, a month or any other suitable time period) that is within a defined heat load range. These are just examples.

The performance level of the respective cooling unit is compared to the performance level of each of the one or more neighboring cooling units, as indicated at block 34b. A determination is made that the respective cooling unit has a reduced relative performance level relative to the neighboring cooling units when the performance level of the respective cooling unit falls below the performance level of one or more of the neighboring cooling units by at least a threshold amount, as indicated at block 34c. In response to determining that at least one of the respective cooling units has a reduced relative performance level, an alert is issued, as indicated at block 36.

In some cases, and continuing with Figure 3B, the method 30 may further include monitoring one or more performance parameters of each of the plurality of cooling units, as indicated at block 38. The method 30 may further include training a machine learning model based at least in part on the one or more performance parameters to model the performance level of each of the plurality of cooling units, as indicated at block 40. The method 30 may further include using a machine learning engine that references the trained machine learning model to compare the performance level of the respective cooling unit (which may include a projected performance level based on the trained machine learning model) to the performance level of each of the one or more neighboring cooling units (which may include a projected performance level based on the trained machine learning model), and to determine when the performance level of the respective cooling unit fall or is expected to fall below the performance level of one or more of the neighboring cooling units by at least the threshold amount, as indicated at block 42.

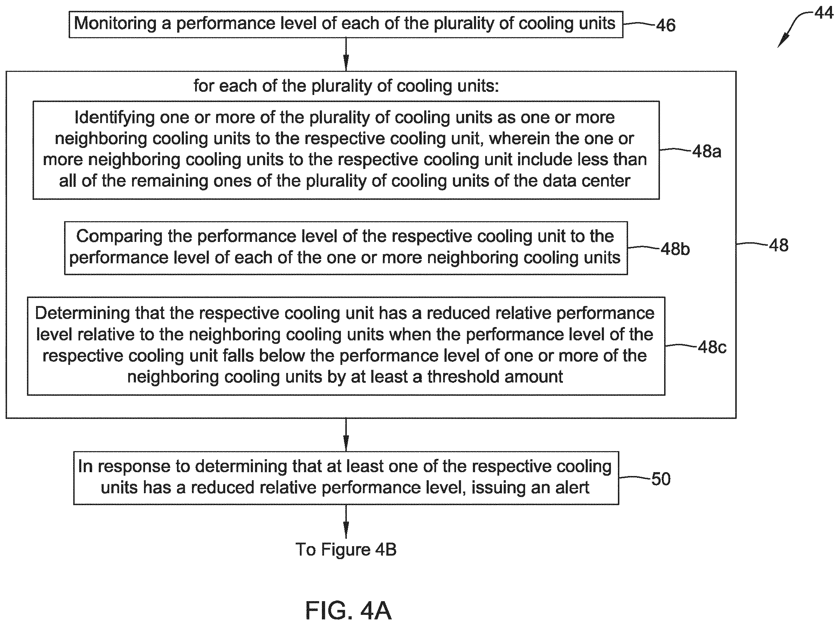

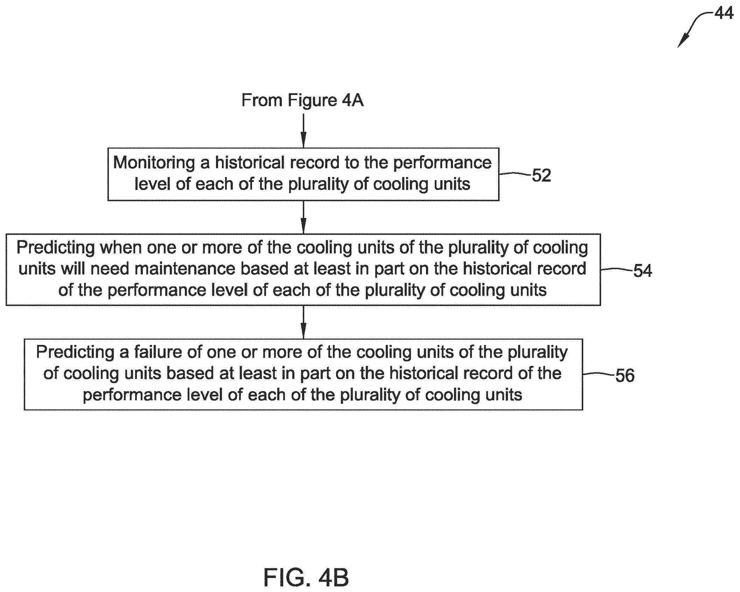

Figures 4A and 4B are flow diagrams that together show an illustrative method 44 of identifying one or more cooling units of a plurality of cooling units (such as the cooling units 14) servicing a data center (such as the data center 10) that has a reduced relative performance level relative to other of the plurality of cooling units. The method 44 includes monitoring a performance level of each of the plurality of cooling units, as indicated at block 46. In some cases, the performance level that is monitored may include an airflow parameter indicative of an air flow through an air filter of the respective cooling unit. The performance level that is monitored may include a temperature drop across a cooling coil of the respective cooling unit. These are just examples.

For each of the plurality of cooling units, as indicated at block 48, a number of steps are carried out. One or more of the plurality of cooling units are identified as one or more neighboring cooling units to the respective cooling unit, wherein the one or more neighboring cooling units to the respective cooling unit include less than all of the remaining ones of the plurality of cooling units of the data center, as indicated at block 48a. The one or more neighboring cooling units may be defined using any suitable criteria. For example, the one or more of the plurality of cooling units identified as neighboring cooling units to the respective cooling unit may be predefined for each respective cooling unit in advance during commissioning of the data center 10. For example, the one or more of the plurality of cooling units identified as neighboring cooling units to the respective cooling unit may be predefined based on having a nearby physical or logical location to the respective cooling unit, such as on a same floor of the data center 10 and/or in a same zone of the data center 10. In another example, the one or more of the plurality of cooling units identified as neighboring cooling units to the respective cooling unit may be predefined based on having an expected heat load that is within a defined heat load range. In some cases, the one or more of the plurality of cooling units identified as neighboring cooling units to the respective cooling unit may be dynamically identified based on one or more sensed conditions. For example, the one or more of the plurality of cooling units identified as neighboring cooling units to the respective cooling unit may be dynamically defined based on having an actual heat load (e.g. an average heat load over a period of a day, a week, a month or any other suitable time period) that is within a defined heat load range. These are just examples.

The performance level of the respective cooling unit is compared to the performance level of each of the one or more neighboring cooling units, as indicated at block 48b. A determination is made that the respective cooling unit has a reduced relative performance level relative to the neighboring cooling units when the performance level of the respective cooling unit falls below the performance level of one or more of the neighboring cooling units by at least a threshold amount, as indicated at block 48c. In response to determining that at least one of the respective cooling units has a reduced relative performance level, an alert is issued, as indicated at block 50.

In some cases, and continuing with Figure 4B, the method 44 may further include maintaining a historical record to the performance level of each of the plurality of cooling units, as indicated at block 52. The method 44 may further include predicting when one or more of the cooling units of the plurality of cooling units will need maintenance based at least in part on the historical record of the performance level of each of the plurality of cooling units, as indicated at block 54. In some cases, the method may include projecting the performance level of the cooling units, and compare the predicted performance level of the respective cooling unit to the predicted performance level of each of the one or more neighboring cooling units, and to determine when the predicted performance level of the respective cooling unit is expected to fall below the predicted performance level of one or more of the neighboring cooling units by at least the threshold amount. In some cases, the method 44 may further include predicting a failure of one or more of the cooling units of the plurality of cooling units based at least in part on the historical record of the performance level of each of the plurality of cooling units, as indicated at block 56.

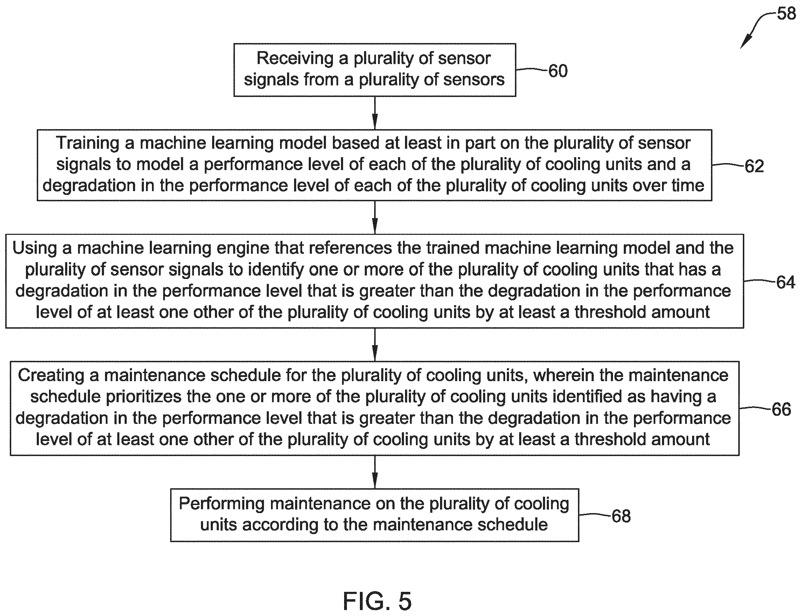

Figure 5 is a flow diagram showing an illustrative method 58 of scheduling maintenance for a plurality of cooling units (such as the cooling units 14) of a data center (such as the data center 10). In some instances, the plurality of cooling units may be part of a predefined group of cooling units (e.g. neighboring cooling units) of the data center 10, and wherein the data center 10 includes at least one other cooling unit that is not part of the predefined group of cooling units. In some cases, the predefined group of cooling units represent cooling units that service a common zone of the data center, service a common floor of the data center, or service a common heat load (e.g. average heat load is within a defined heat load range).

The illustrative method 58 includes receiving a plurality of sensor signals from a plurality of sensors, as indicated at block 60. In some cases, the plurality of sensor signals may include one or more of a plurality of airflow signals indicative of an air flow through an air filter of each of the plurality of cooling units, and/or a plurality of temperature drop signals indicative of a temperature drop across a cooling coil of each of the plurality of cooling units. These are just examples.

A machine learning model is trained based at least in part on the plurality of sensor signals to model a performance level of each of the plurality of cooling units and a degradation in the performance level of each of the plurality of cooling units over time, as indicated at block 62. In some cases, training the machine learning model occurs during a training mode. A machine learning engine that references the trained machine learning model and the plurality of sensor signals is used to identify one or more of the plurality of cooling units that has a degradation in the performance level (which may include a projected degradation in the performance level based on the trained machine learning model) that is greater than the degradation in the performance level (which may include a projected degradation in the performance level based on the trained machine learning model) of at least one other of the plurality of cooling units in the predefined group of cooling units by at least a threshold amount, as indicated at block 64. In some cases, this occurs during an operational mode.

A maintenance schedule is created for the plurality of cooling units, wherein the maintenance schedule prioritizes the one or more of the plurality of cooling units identified as having a degradation in the performance level that is greater than the degradation in the performance level of at least one other of the plurality of cooling units in the predefined group by at least a threshold amount, as indicated at block 66. Maintenance is performed on the plurality of cooling units according to the maintenance schedule, as indicated at block 68.

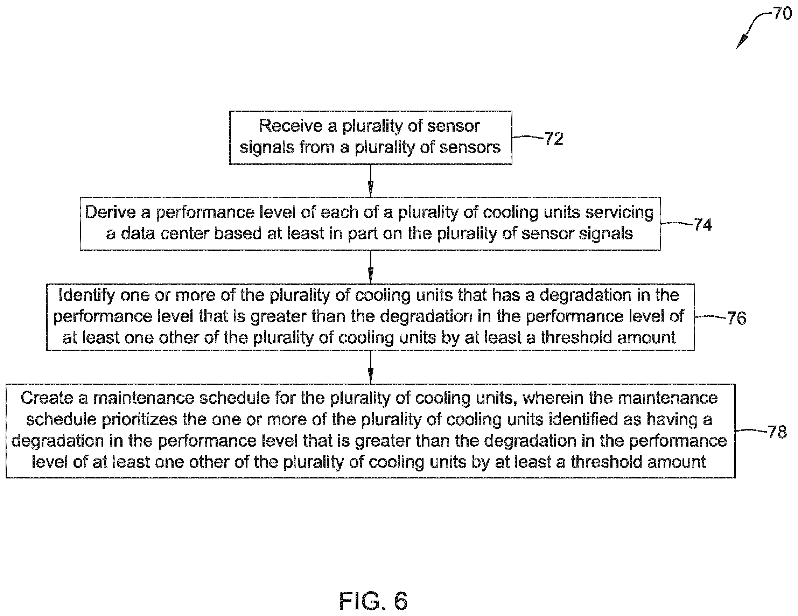

Figure 6 is a flow diagram showing an illustrative series of steps 70 that may be carried out by one or more processors when executing instructions that are stored on a non-transient, computer readable storage medium. The one or more processors may be caused to receive a plurality of sensor signals from a plurality of sensors, as indicated at block 72. The one or more processors may be caused to derive a performance level of each of a plurality of cooling units servicing a data center based at least in part on the plurality of sensor signals, as indicated at block 74. The one or more processors may be caused to identify one or more of the plurality of cooling units that has a degradation in the performance level that is greater than the degradation in the performance level of at least one other of the plurality of cooling units by at least a threshold amount, as indicated at block 76.

In some cases, the one or more processors may be caused to identify the plurality of cooling units from a larger set of cooling units that service the data center, wherein the plurality of cooling units represent cooling units that service a common zone of the data center, service a common floor of the data center, or service a common heat load (e.g. average heat load over a period of time that is within a defined heat load range). The one or more processors may be caused to create a maintenance schedule for the plurality of cooling units, wherein the maintenance schedule prioritizes the one or more of the plurality of cooling units identified as having a degradation in the performance level that is greater than the degradation in the performance level of at least one other of the plurality of cooling units by at least a threshold amount, as indicated at block 78.

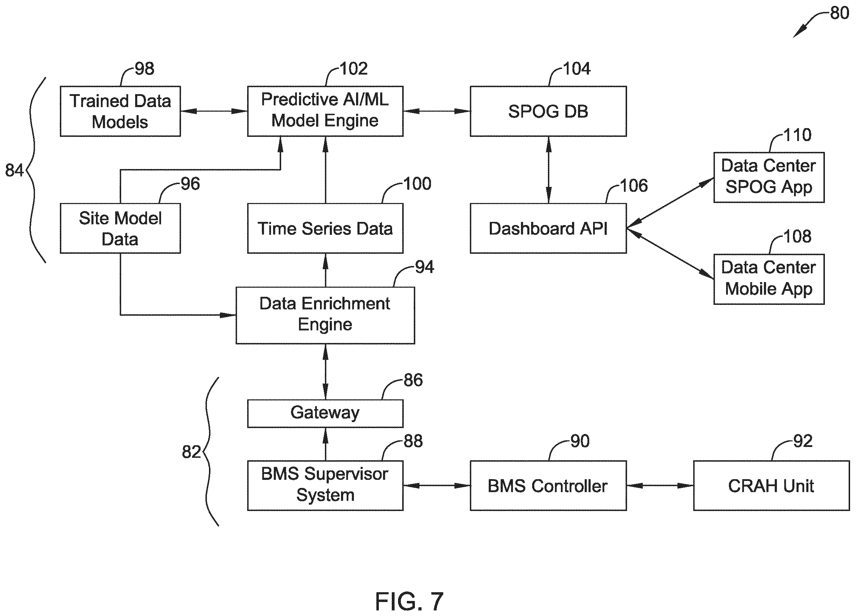

Figure 7 is a schematic block diagram showing an illustrative system 80 that may be considered as being divided into an edge, or local, component 82 and a cloud, or remote, component 84. Within the local component 82, an edge gateway 86 collects data from a Building Management System (BMS) Supervisor System 88, which itself collects data from a BMS controller 90. The BMS controller 90 receives data from, and controls operation of, a cooling unit such as a CRAH unit 92.

In the example shown, the cloud component 84 includes a data enrichment engine 94 that communicates with the edge gateway 86. The data enrichment engine 94 also provides data to a Site Model Data block 96, a Trained Data Models block 98 and a Time Series Data block 98. The Site Model Data block 96, the Trained Data Models block 98 and the Time Series Data block 100 each provide information to a Predictive AI (artificial intelligence)/ML (machine learning) Model Engine 102. The Predictive AI/MI, Model Engine 102 communicates with a SPOG database 104, which itself communicates with a dashboard 106. It will be appreciated that the dashboard 106 may be accessed via either a data center mobile application 108 or a data center SPOG application 110.

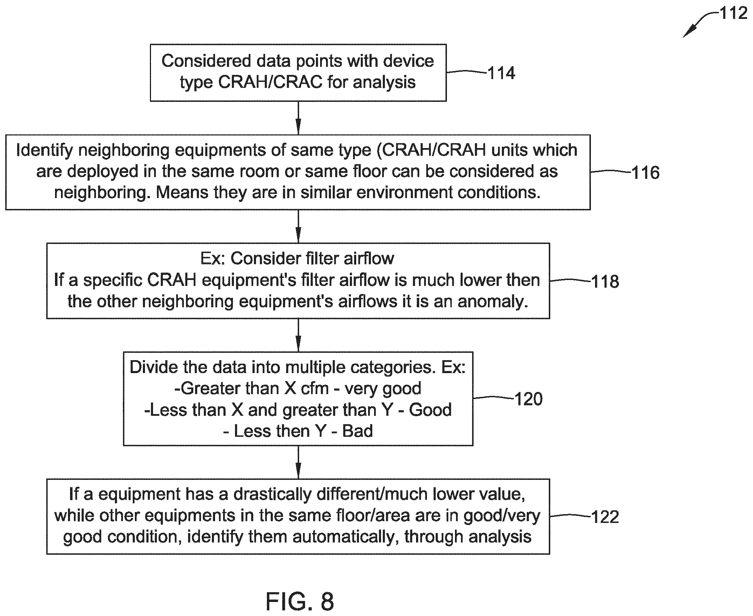

Figure 8 is a flow diagram showing an illustrative sample anomaly prediction method 112. The method 112 includes considering cooling unit data for analysis, as indicated at block 114. Cooling units that are similar, and that are neighboring, are identified, as indicated at block 116. The method 112 includes looking for anomalies, as indicated at block 118. As an example, if a particular CRAH unit has a filter airflow value that is much lower than that of neighboring CRAH units, this is considered an anomaly. The data is categorized as good, very good or bad, as indicated at block 120. In some cases, equipment that has substantially lower values than other equipment in the same area, this equipment may be automatically identified as problematic, as indicated at block 122.

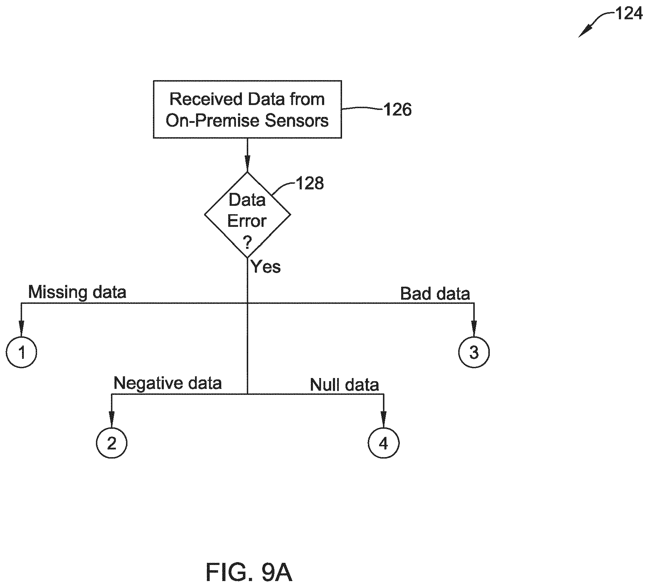

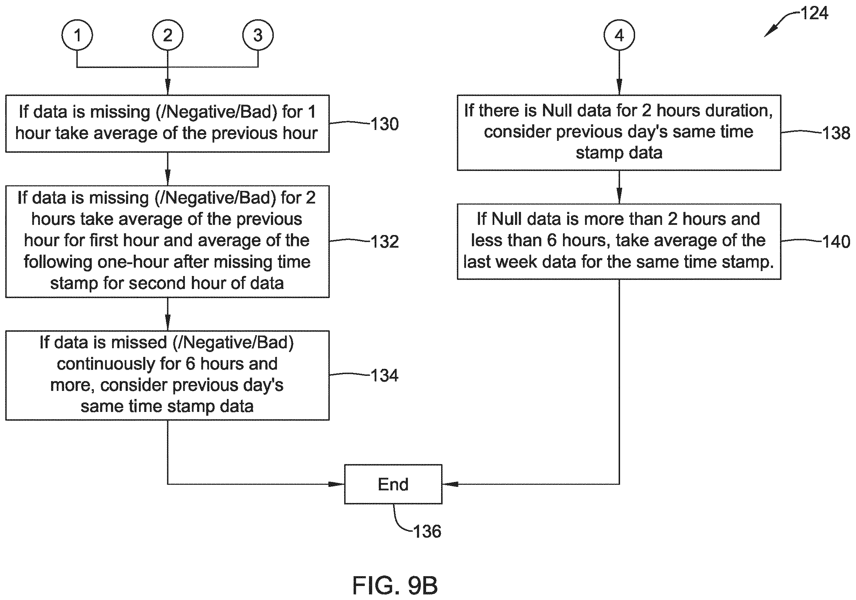

Figures 9A and 9B are flow diagrams that together show an illustrative method 124 of data enrichment. In some cases, the method 124 of data enrichment may be carried out via the data enrichment engine 94 of Figure 7. Data is received from sensors, as indicated at block 126. At decision block 128, a determination is made as to whether any of the received data is missing, bad, negative or null. If not, the data is processed normally. If any of the received data is determined to include missing data, control passes to point "1". If any of the received data is determined to include negative data, control passes to point "2". If any of the received data is determined to include bad data, control passes to point "3". If any of the received data is determined to include null data, control passes to point "4".

The method 124 continues in Figure 9B. If any of the received data was determined to include missing data, negative data or bad data for up to one hour, control passes to block 130, where an average value for the previous hour is determined. If any of the received data was determined to include missing data, negative data or bad data for up to two hours, control passes to block 132, where an average value for the previous hour is taken for the first hour of missing data and an average value for a following hour is taken for the second hour of missing data. If any of the received data was determined to include missing data, negative data or bad data for more than six hours, control passes to block 134, where an average value for the previous day is determined. Control then passes to an end block 136.

If there was a determination of null data for up to two hours duration, control passes to block 138, where a previous day's data for the same time period is used. If the null data exceeds two hours, but not more than six hours, an average is taken of the previous week's data for the same time period, as indicated at block 140.

Those skilled in the art will recognize that the present disclosure may be manifested in a variety of forms other than the specific embodiments described and contemplated herein. Accordingly, departure in form and detail may be made without departing from the scope of the present disclosure as described in the appended claims.

## Claims

1. A method of identifying one or more cooling units of a plurality of cooling units (14) servicing a data center (10) that has a reduced relative performance level relative to other of the plurality of cooling units, the method comprising:
monitoring a performance level of each of the plurality of cooling units, wherein the plurality of cooling units include computer room air conditioner (CRAC) units and/or computer room air handler (CRAH) units; **characterized in that**
for each of the plurality of cooling units:
identifying one or more of the plurality of cooling units as one or more neighboring cooling units to the respective cooling unit, wherein the one or more neighboring cooling units to the respective cooling unit include less than all of the remaining ones of the plurality of cooling units of the data center;
comparing the performance level of the respective cooling unit to the performance level of each of the one or more neighboring cooling units;
determining that the respective cooling unit has a reduced relative performance level relative to the neighboring cooling units when the performance level of the respective cooling unit falls below the performance level of one or more of the neighboring cooling units by at least a threshold amount; and
in response to determining that at least one of the respective cooling units has a reduced relative performance level, issuing an alert.

2. The method of claim 1, further comprising:
determining a priority of maintenance for the plurality of cooling units servicing the data center based at least in part on the alert.

3. The method of claim 1, wherein the one or more neighboring cooling units and the respective cooling unit all service a common zone of the data center.

4. The method of claim 1, wherein the one or more neighboring cooling units and the respective cooling unit all service a common floor of the data center.

5. The method of claim 1, wherein the one or more neighboring cooling units and the respective cooling unit all service a common geographic region of the data center, wherein at least one of the plurality of cooling units that is not one of the one or more neighboring cooling units services a geographic region of the data center that than is outside of the common geographic region.

6. The method of claim 1, wherein the one or more neighboring cooling units and the respective cooling unit all service a heat load that is within a defined heat load range.

7. The method of claim 1, wherein the performance level that is monitored comprises an airflow parameter indicative of an air flow through an air filter of the respective cooling unit.

8. The method of claim 1, wherein the performance level that is monitored comprises a temperature drop across a cooling coil of the respective cooling unit.

9. The method of claim 1, further comprising:
monitoring one or more performance parameters of each of the plurality of cooling units;
training a machine learning model based at least in part on the one or more performance parameters to model the performance level of each of the plurality of cooling units; and
using a machine learning engine that references the trained machine learning model to compare the performance level of the respective cooling unit to the performance level of each of the one or more neighboring cooling units, and to determine when the performance level of the respective cooling unit fall or is expected to fall below the performance level of one or more of the neighboring cooling units by at least the threshold amount.

10. The method of claim 1, wherein the one or more of the plurality of cooling units identified as neighboring cooling units to the respective cooling unit are predefined.

11. The method of claim 1, wherein the one or more of the plurality of cooling units identified as neighboring cooling units to the respective cooling unit are dynamically identified.

12. The method of claim 1, further comprising:
maintaining a historical record to the performance level of each of the plurality of cooling units; and
predicting when one or more of the cooling units of the plurality of cooling units will need maintenance based at least in part on the historical record of the performance level of each of the plurality of cooling units.

13. The method of claim 12, further comprising:
predicting a failure of one or more of the cooling units of the plurality of cooling units based at least in part on the historical record of the performance level of each of the plurality of cooling units.

14. A non-transient computer readable medium storing instructions thereon that when executed by one or more processors cause the one or more processors to:
receive a plurality of sensor signals from a plurality of sensors (16); **characterized by** deriving a performance level of each of a plurality of cooling units (14) servicing a data cente (10) based at least in part on the plurality of sensor signals, wherein the plurality of cooling units include computer room air conditioner (CRAC) units and/or computer room air handler (CRAH) units;
identifying one or more of the plurality of cooling units that has a degradation in the performance level that is greater than the degradation in the performance level of at least one other of the plurality of cooling units by at least a threshold amount; and
creating create a maintenance schedule for the plurality of cooling units, wherein the maintenance schedule prioritizes the one or more of the plurality of cooling units identified as having a degradation in the performance level that is greater than the degradation in the performance level of at least one other of the plurality of cooling units by at least a threshold amount.

15. The non-transient computer readable medium of claim 14, wherein the instructions cause the one or more processors to identify the plurality of cooling units from a larger set of cooling units that service the data center, wherein the plurality of cooling units represent cooling units that:
service a common zone of the data center;
service a common floor of the data center; or
service a heat load that is within a defined heat load range.

## Patentansprüche

1. Verfahren zum Identifizieren von einer oder mehreren Kühleinheiten einer Vielzahl von Kühleinheiten (14), die ein Datenzentrum (10) bedienen, die ein reduziertes relatives Leistungsniveau relativ zu einer anderen der Vielzahl von Kühleinheiten aufweist, das Verfahren umfassend:
Überwachen eines Leistungsniveaus jeder der Vielzahl von Kühleinheiten, wobei die Vielzahl von Kühleinheiten Computerraumklimaanlagen (CRAC)-Einheiten und/oder Computerraumlufthandhabungs (CRAH)-Einheiten beinhalten, **gekennzeichnet dadurch, dass**
für jede der Vielzahl von Kühleinheiten:
Identifizieren von einer oder mehreren der Vielzahl von Kühleinheiten als eine oder mehrere benachbarte Kühleinheiten zu der jeweiligen Kühleinheit, wobei die eine oder die mehreren benachbarten Kühleinheiten zu der jeweiligen Kühleinheit weniger als alle der restlichen der Vielzahl von Kühleinheiten des Datenzentrums beinhalten;
Vergleichen des Leistungsniveaus der jeweiligen Kühleinheit mit dem Leistungsniveau von jeder der einen oder der mehreren benachbarten Kühleinheiten;
Bestimmen, dass die jeweilige Kühleinheit ein reduziertes relatives Leistungsniveau relativ zu den benachbarten Kühleinheiten aufweist, wenn das Leistungsniveau der jeweiligen Kühleinheit um mindestens einen Schwellenbetrag unter das Leistungsniveau von einer oder mehreren der benachbarten Kühleinheiten sinkt; und
als Antwort auf das Bestimmen, dass mindestens eine der jeweiligen Kühleinheiten ein reduziertes relatives Leistungsniveau aufweist, Ausgeben eines Alarms.

2. Verfahren nach Anspruch 1, ferner umfassend:
Bestimmen einer Wartungspriorität für die Vielzahl von Kühleinheiten, die das Datenzentrum bedienen, mindestens teilweise auf Basis des Alarms.

3. Verfahren nach Anspruch 1, wobei die eine oder die mehreren benachbarten Kühleinheiten und die jeweilige Kühleinheit alle eine gemeinsame Zone des Datenzentrums bedienen.

4. Verfahren nach Anspruch 1, wobei die eine oder die mehreren benachbarten Kühleinheiten und die jeweilige Kühleinheit alle ein gemeinsames Stockwerk des Datenzentrums bedienen.

5. Verfahren nach Anspruch 1, wobei die eine oder die mehreren benachbarten Kühleinheiten und die jeweilige Kühleinheit alle eine gemeinsame geographische Region des Datenzentrums bedienen, wobei mindestens eine der Vielzahl von Kühleinheiten, die nicht einer der einen oder der mehreren benachbarten Kühleinheiten ist, eine geographische Region des Datenzentrums bedient, die außerhalb der gemeinsamen geographischen Region liegt.

6. Verfahren nach Anspruch 1, wobei die eine oder die mehreren benachbarten Kühleinheiten und die jeweilige Kühleinheit alle eine Wärmelast bedienen, die innerhalb eines definierten Wärmelastbereichs liegt.

7. Verfahren nach Anspruch 1, wobei das Leistungsniveau, das überwacht wird, einen Luftstromparameter umfasst, der angebend für einen Luftstrom durch einen Luftfilter der jeweiligen Kühleinheit ist.

8. Verfahren nach Anspruch 1, wobei das Leistungsniveau, das überwacht wird, einen Temperaturabfall über eine Kühlspule der jeweiligen Kühleinheit umfasst.

9. Verfahren nach Anspruch 1, ferner umfassend:
Überwachen eines oder mehrerer Leistungsparameter von jeder der Vielzahl von Kühleinheiten;
Trainieren eines Maschinenlernen-Modells mindestens teilweise auf Basis des einen oder der mehreren Leistungsparameter, um das Leistungsniveau von jeder der Vielzahl von Kühleinheiten zu modellieren; und
Verwenden einer Maschinenlernen-Engine, die das trainierte Maschinenlernen-Modell referenziert, um das Leistungsniveau der jeweiligen Kühleinheit mit dem Leistungsniveau von jeder der einen oder der mehreren benachbarten Kühleinheiten zu vergleichen und zu bestimmen, wenn das Leistungsniveau der jeweiligen Kühleinheit um mindestens den Schwellenbetrag unter das Leistungsniveau von einer oder mehreren der benachbarten Kühleinheiten sinkt oder voraussichtlich sinken wird.

10. Verfahren nach Anspruch 1, wobei die eine oder die mehreren der Vielzahl von Kühleinheiten, die als benachbarte Kühleinheiten zu der jeweiligen Kühleinheit identifiziert sind, vordefiniert sind.

11. Verfahren nach Anspruch 1, wobei die eine oder die mehreren der Vielzahl von Kühleinheiten, die als benachbarte Kühleinheiten zu der jeweiligen Kühleinheit identifiziert sind, dynamisch identifiziert werden.

12. Verfahren nach Anspruch 1, ferner umfassend:
Führen einer historischen Aufzeichnung des Leistungsniveaus von jeder der Vielzahl von Kühleinheiten; und
Vorhersagen, wenn eine oder mehrere der Kühleinheiten der Vielzahl von Kühleinheiten Wartung erfordern, mindestens teilweise auf Basis der historischen Aufzeichnung des Leistungsniveaus von jeder der Vielzahl von Kühleinheiten.

13. Verfahren nach Anspruch 12, ferner umfassend:
Vorhersagen eines Ausfalls von einer oder mehrerer der Kühleinheiten der Vielzahl von Kühleinheiten mindestens teilweise auf Basis der historischen Aufzeichnung des Leistungsniveaus von jeder der Vielzahl von Kühleinheiten.

14. Nicht-flüchtiges computerlesbares Medium, das Anweisungen darauf speichert, die bei ihrer Ausführung durch einen oder mehrere Prozessoren den einen oder die mehreren Prozessoren dazu veranlassen:
eine Vielzahl von Sensorsignalen von einer Vielzahl von Sensoren (16) zu empfangen;
**gekennzeichnet durch** Ableiten eines Leistungsniveaus jeder einer Vielzahl von Kühleinheiten (14), die ein Datenzentrum (10) bedienen, mindestens teilweise auf Basis der Vielzahl von Sensorsignalen, wobei die Vielzahl von Kühleinheiten Computerraumklimaanlagen (CRAC)-Einheiten und/oder Computerraumlufthandhabungs (CRAH)-Einheiten beinhalten;
Identifizieren einer oder mehrerer der Vielzahl von Kühleinheiten, die eine Verschlechterung des Leistungsniveaus aufweisen, die um mindestens einen Schwellenbetrag größer ist als die Verschlechterung des Leistungsniveaus von mindestens einer anderen der Vielzahl von Kühleinheiten; und
Erstellen eines Wartungsplans für die Vielzahl von Kühleinheiten, wobei der Wartungsplan die eine oder die mehreren der Vielzahl von Kühleinheiten priorisiert, die dazu identifiziert werden, dass sie eine Verschlechterung des Leistungsniveaus aufweisen, die um mindestens einen Schwellenbetrag größer ist als die Verschlechterung des Leistungsniveaus von mindestens einer anderen der Vielzahl von Kühleinheiten.

15. Nicht-flüchtiges computerlesbares Medium nach Anspruch 14, wobei die Anweisungen den einen oder die mehreren Prozessoren dazu veranlassen, die Vielzahl von Kühleinheiten aus einem größeren Satz von Kühleinheiten, die das Datenzentrum bedienen, zu identifizieren, wobei die Vielzahl von Kühleinheiten Kühleinheiten darstellen, die:
eine gemeinsame Zone des Datenzentrums bedienen;
ein gemeinsames Stockwerk des Datenzentrums bedienen; oder
eine Wärmelast bedienen, die innerhalb eines definierten Wärmelastbereichs liegt.

## Revendications

1. Procédé d'identification d'une ou plusieurs unités de refroidissement parmi une pluralité d'unités de refroidissement (14) desservant un centre de données (10) qui présente un niveau de performance relatif réduit par rapport aux autres de la pluralité d'unités de refroidissement, le procédé comprenant :
la surveillance d'un niveau de performance de chacune de la pluralité d'unités de refroidissement, dans lequel la pluralité d'unités de refroidissement inclut des unités de climatisation de salle informatique (CRAC) et/ou des unités de traitement de l'air de salle informatique (CRAH) ; **caractérisé en ce que**
pour chacune de la pluralité d'unités de refroidissement :
l'identification d'une ou plusieurs parmi la pluralité d'unités de refroidissement en tant qu'une ou plusieurs unités de refroidissement voisines de l'unité de refroidissement respective, dans lequel les une ou plusieurs unités de refroidissement voisines de l'unité de refroidissement respective incluent moins que la totalité de la pluralité d'unités de refroidissement restantes du centre de données ;
la comparaison du niveau de performance de l'unité de refroidissement respective au niveau de performance de chacune des une ou plusieurs unités de refroidissement voisines ;
la détermination que l'unité de refroidissement respective a un niveau de performance relatif réduit par rapport aux unités de refroidissement voisines lorsque le niveau de performance de l'unité de refroidissement respective tombe en dessous du niveau de performance d'une ou plusieurs des unités de refroidissement voisines d'au moins une quantité seuil ; et
en réponse à la détermination qu'au moins une des unités de refroidissement respectives a un niveau de performance relatif réduit, l'émission d'une alerte.

2. Procédé selon la revendication 1, comprenant en outre :
la détermination d'une priorité de maintenance pour la pluralité d'unités de refroidissement desservant le centre de données sur la base au moins en partie de l'alerte.

3. Procédé selon la revendication 1, dans lequel les une ou plusieurs unités de refroidissement voisines et l'unité de refroidissement respective desservent toutes une zone commune du centre de données.

4. Procédé selon la revendication 1, dans lequel les une ou plusieurs unités de refroidissement voisines et l'unité de refroidissement respective desservent toutes un étage commun du centre de données.

5. Procédé selon la revendication 1, dans lequel les une ou plusieurs unités de refroidissement voisines et l'unité de refroidissement respective desservent toutes une région géographique commune du centre de données, dans lequel au moins une de la pluralité d'unités de refroidissement qui n'est pas une parmi les une ou plusieurs unités de refroidissement voisines dessert une région géographique du centre de données qui est à l'extérieur de la région géographique commune.

6. Procédé selon la revendication 1, dans lequel les une ou plusieurs unités de refroidissement voisines et l'unité de refroidissement respective desservent toutes une charge thermique comprise dans une plage de charge thermique définie.

7. Procédé selon la revendication 1, dans lequel le niveau de performance qui est surveillé comprend un paramètre de flux d'air indiquant un flux d'air à travers un filtre à air de l'unité de refroidissement respective.

8. Procédé selon la revendication 1, dans lequel le niveau de performance qui est surveillé comprend une chute de température au travers d'une bobine de refroidissement de l'unité de refroidissement respective.

9. Procédé selon la revendication 1, comprenant en outre :
la surveillance d'un ou plusieurs paramètres de performance de chacune de la pluralité d'unités de refroidissement ;
l'entraînement d'un modèle d'apprentissage automatique sur la base au moins en partie des un ou plusieurs paramètres de performance pour modéliser le niveau de performance de chacune de la pluralité d'unités de refroidissement ; et
l'utilisation d'un moteur d'apprentissage automatique qui référence le modèle d'apprentissage automatique entraîné pour comparer le niveau de performance de l'unité de refroidissement respective au niveau de performance de chacune des une ou plusieurs unités de refroidissement voisines, et pour déterminer le moment où le niveau de performance de l'unité de refroidissement respective tombe ou est susceptible de tomber en dessous du niveau de performance d'une ou plusieurs des unités de refroidissement voisines d'au moins la quantité seuil.

10. Procédé selon la revendication 1, dans lequel les une ou plusieurs de la pluralité d'unités de refroidissement identifiées en tant qu'unités de refroidissement voisines de l'unité de refroidissement respective sont prédéfinies.

11. Procédé selon la revendication 1, dans lequel les une ou plusieurs parmi la pluralité d'unités de refroidissement identifiées en tant qu'unités de refroidissement voisines de l'unité de refroidissement respective sont identifiées de manière dynamique.

12. Procédé selon la revendication 1, comprenant en outre :
la conservation d'un historique du niveau de performance de chacune de la pluralité d'unités de refroidissement ; et
la prédiction du moment où une ou plusieurs des unités de refroidissement parmi la pluralité d'unités de refroidissement auront besoin d'une maintenance sur la base au moins en partie de l'historique du niveau de performance de chacune de la pluralité d'unités de refroidissement.

13. Procédé selon la revendication 12, comprenant en outre :
la prédiction d'une défaillance d'une ou plusieurs des unités de refroidissement parmi la pluralité d'unités de refroidissement sur la base au moins en partie de l'historique du niveau de performance de chacune de la pluralité d'unités de refroidissement.

14. Support non transitoire lisible par ordinateur sur lequel sont stockées des instructions qui lorsqu'elles sont exécutées par un ou plusieurs processeurs amènent les un ou plusieurs processeurs à :
recevoir une pluralité de signaux de capteur d'une pluralité de capteurs (16) ;
**caractérisé par** la déduction d'un niveau de performance de chacune d'une pluralité d'unités de refroidissement (14) desservant un centre de données (10) sur la base au moins en partie de la pluralité de signaux de capteur, dans lequel la pluralité d'unités de refroidissement incluent des unités de climatisation de salle informatique (CRAC) et/ou des unités de traitement de l'air de salle informatique (CRAH) ;
l'identification d'une ou plusieurs parmi la pluralité d'unités de refroidissement qui présente une dégradation du niveau de performance qui est supérieure à la dégradation du niveau de performance d'au moins une autre parmi la pluralité d'unités de refroidissement d'au moins une quantité seuil ; et
la création d'un programme de maintenance pour la pluralité d'unités de refroidissement, dans lequel le programme de maintenance priorise les une ou plusieurs parmi la pluralité d'unités de refroidissement identifiées comme présentant une dégradation du niveau de performance qui est supérieure à la dégradation du niveau de performance d'au moins une autre parmi la pluralité d'unités de refroidissement d'au moins une quantité seuil.

15. Support non transitoire lisible par ordinateur selon la revendication 14, dans lequel les instructions amènent les un ou plusieurs processeurs à identifier la pluralité d'unités de refroidissement parmi un ensemble plus grand d'unités de refroidissement qui desservent le centre de données, dans lequel la pluralité d'unités de refroidissement représentent des unités de refroidissement qui :
desservent une zone commune du centre de données ;
desservent un étage commun du centre de données ; ou
desservent une charge thermique qui est au sein d'une plage de charge thermique définie.
